# EUROPEAN PATENT SPECIFICATION

(11) **EP 1 574 132 B1**
(45) Date of publication and mention of the grant of the patent: **30.11.2011**
(21) Application number: 04256168.8
(22) Date of filing: 06.10.2004
(51) Int. Cl.: A01N 59/16, A01N 59/20, A47K 10/04, A01N 25/34

(54) **Antimicrobial sanitary ware and method for making the same**
Antimikrobielle Sanitärartikel und Verfahren zu ihrer Herstellung
Articles sanitaires antimicrobiens et procédé pour leur fabrication

(30) Priority: 10.03.2004 US 797818
(43) Date of publication of application: 14.09.2005
(73) Proprietor: Globe Union Industrial Corp., Taichung (TW)
(72) Inventor: Lo, Wen-Li, Taichung (TW)
(74) Representative: Adamson Jones

(56) References cited:
- EP-A- 0 636 375
- EP-A- 0 653 161
- WO-A-95/13704
- US-A1- 2001 008 698
- US-A1- 2003 113 543
- US-B1- 6 303 183

## Description

This invention relates to an antimicrobial sanitary ware and a method for making the same, more particularly to an antimicrobial sanitary ware with a metal particle-containing antimicrobial film and a method for making the same.

Conventional sanitary wares, such as towel bars, robe hangers, faucets, shower heads, shelves, soap holders, paper holders, tumbler holders, door knobs etc., are normally coated with a protective film made from metal nitride or metal carbide so as to provide a smooth surface and resistance to corrosion and wearing for the sanitary wares. The protective film is formed on a substrate of the sanitary ware by sputtering techniques, such as unbalanced magnetron sputtering. US 2003/113543 discloses multi-layer decorative and corrosion resistant coatings on plastic, ceramic or metallic articles, wherein a refractory metal nitride or refractory metal alloy nitride coating is applied over a polymeric base coat by vapour deposition methods. US 2001/008698 discloses coatings with a colour-imparting nitride layer for bath fixtures which are applied directly on the article or on a base coating using magnetron sputtering techniques.

EP 653161 discloses an antimicrobial mildewproof glaze for ceramic sanitary ware comprising a silver-containing substance, EP 636375 discloses antimicrobial metal or metal alloy coatings (silver or copper/tin) for sanitary ware and US 6303183 discloses an antimicrobial porcelain enamel coating for sanitary ware having dispersed therein an antimicrobial agent comprising silver, zinc &/or copper on a particulate support, for example titanium dioxide or zinc oxide. WO 9513704 discloses antimicrobial coatings in the field of medical devices, said coatings comprising modified antimicrobial metals which may be applied by vapour deposition techniques. The antimicrobial metals, including silver, copper and zinc, are modified to introduce atomic disorder such that sustained release of the antimicrobial metal species occurs when in contact with an alcohol or electrolyte. The modified metal may be in the form of a composite with inert materials, including materials such as nitrides or carbides.

Since sanitary wares are constantly exposed to moisture-rich atmosphere, it is desirable to prevent or mitigate the growth of bacteria or fouling on the sanitary wares while maintaining the resistance to corrosion and wearing.

Therefore the present invention seeks to provide an antimicrobial sanitary ware with an antimicrobial film that is capable of mitigating the growth of bacteria while maintaining the resistance to corrosion and wearing.

According to one aspect of the present invention, there is provided an antimicrobial sanitary ware that comprises: a substrate; and an antimicrobial film formed on the substrate and comprising a protective layer and antimicrobial metal particles that are dispersed in the protective layer. The protective layer is made from a compound selected from the group consisting of metal nitrides and metal carbides. The antimicrobial metal particles are made from a metal selected from the group consisting of silver, zinc, and copper.

According to another aspect of the present invention, there is provided a method for making an antimicrobial sanitary ware. The method comprises the steps of: placing a substrate in a sputtering chamber in a sputter; and simultaneously sputtering a first metal target of a first metal and a second metal target of a second metal through closed-field unbalanced magnetron sputtering techniques, which form a continuously closed magnetic field around the substrate, so as to react the first metal into a metal compound which is subsequently deposited on the substrate to form a protective layer, and so as to generate metal particles of the second metal that are dispersed in the protective layer. The second metal is selected from the group consisting of silver, zinc, and copper. The metal compound is selected from the group consisting of metal nitrides and metal carbides. In the method, the sputtering for the second metal target is conducted at a voltage of less than 20V, and a current ranging from 0.3-0.5A and a negative biased voltage of greater than - 80V is applied to said substrate.

The present invention will now be described in a non-limitative sense with reference to the accompanying Figures in which:
Fig. 1 is a block diagram illustrating consecutive steps of the preferred embodiment of a method for making an antimicrobial sanitary ware according to the present invention; and
Fig. 2 is a cutaway view of the preferred embodiment of the antimicrobial sanitary ware formed according to the method of this invention.

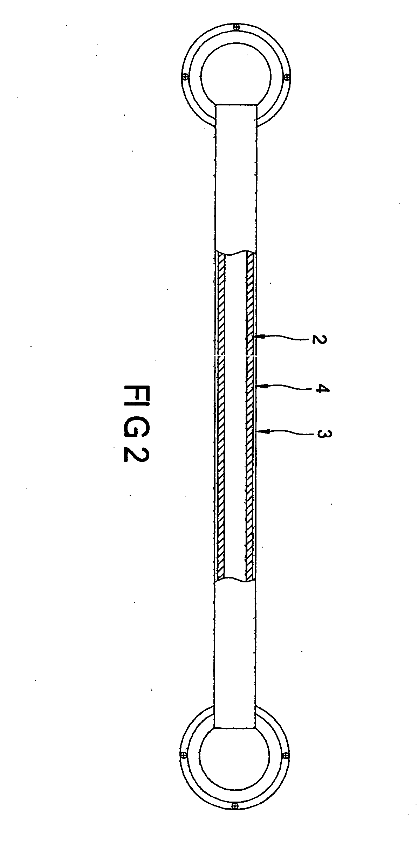

Fig. 2 illustrates the preferred embodiment of an antimicrobial sanitary ware, such as the aforesaid sanitary wares, according to the present invention. The antimicrobial sanitary ware includes: a substrate 2; and an antimicrobial film formed on the substrate 2 and comprising a protective layer 3 and antimicrobial metal particles 4 that are dispersed in the protective layer 3. The protective layer 3 is made from a metal compound selected from the group consisting of metal nitrides and metal carbides.

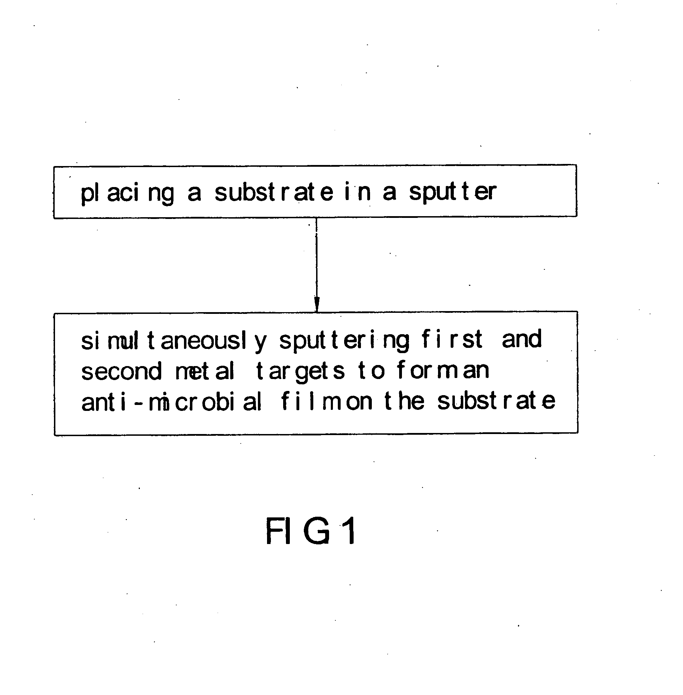

Referring to Fig. 1, in combination with Fig. 2, the method of forming the antimicrobial sanitary ware involves the use of closed-field unbalanced magnetron sputtering (CFUBMS) techniques, and includes the steps of: placing the substrate 3 in a sputter (not shown); and simultaneously sputtering a first metal target of a first metal and a second metal target of a second metal so as to react the first metal into the metal compound which is subsequently deposited on the substrate 2 to form the protective layer 3, and so as to generate the antimicrobial metal particles 4 of the second metal that are dispersed in the protective layer 3. The metal particles 4 thus formed have a particle size less than 100 nanometers.

The second metal, which forms the antimicrobial metal particles 4, is selected from the group consisting of silver, zinc, and copper.

Preferably, the first metal is selected from the group consisting of zirconium, chromium, and titanium.

Preferably, the metal compound is metal nitride, and is selected from the group consisting of zirconium nitride, chromium nitride, and titanium nitride.

Preferably, the substrate is made from a material selected from the group consisting of copper alloy, zinc alloy, stainless steel, ceramics, and plastics.

The first metal sputtered from the first metal target reacts with a reactive gas, such as nitrogen, methane, or acetylene, in a sputtering chamber of the sputter (not shown) so as to form the metal compound.

Preferably, the sputtering of the first metal target is conducted at a voltage ranging from 20-50V, and a current ranging from 3.5-4.5A, whereas the sputtering of the second metal target is conducted at a voltage less than 20V, and a current ranging from 0.3-0.5A. A negative biased voltage of greater than -80V is applied to the substrate 2.

Preferably, the sputtering is conducted at a temperature ranging from 80-180 °C, and a pressure ranging from 0.013-2.667 Pa (0.1-20 mTorr) for 3-13 minutes.

The present invention will be described in more detail in the following Example.

### Example 1

A substrate was subjected to milling and polishing, followed by cleaning and drying. The cleaned substrate was then prepared for deposition of the antimicrobial film using CFUBMS techniques, and was placed in a sputtering chamber which was filled with nitrogen and argon gas and which was provided with silver target and zirconium target. During the sputtering operation, a negative biased voltage of -50V was applied to the substrate, a positive biased voltage of less than 20V (with 0.4A current) was applied to the silver target, and a positive biased voltage of 30V (with 4.0A current) was applied to the zirconium target. The sputtering operation was conducted at a temperature of 180°C and a pressure of 0.147 Pa (1.1 mTorr) for 13 minutes so as to form an antimicrobial film (Ag-ZrN) on the substrate.

The thus formed antimicrobial sanitary ware was then subjected to antimicrobial activity tests in accordance with JIS Z 2801:2000 (Japanese Industry Standard).

The results show that the antimicrobial activity of the thus formed antimicrobial sanitary ware for escherichia coli is above 99.999%, and is above 99.9% for staphylococcus aureus and pseudomonas aeruginosa.

Since escape of the generated plasma in the sputtering chamber is effectively prevented by using CFUBMS techniques, which form a continuously closed magnetic field around the substrate, and since the generated plasma is confined in the continuously closed magnetic field, collision and ionization of molecules in the chamber are considerably increased, which result in an increase in the deposition of the material to be deposited on the substrate, which, in turn, results in an increase in the compactness and bulk density of the antimicrobial film deposited on the substrate. As a consequence, the resistance to corrosion and wearing of the antimicrobial sanitary ware of this invention is considerably enhanced.

The antimicrobial functions provided by the antimicrobial sanitary ware of this invention include one that interferes with the synthesis of the cell wall of bacteria, one that damages the cell membrane of bacteria, and one that interferes with the synthesis of nucleic acid. As a result of ionization, the metal particles 4 in the protective layer 3 of the antimicrobial sanitary ware of this invention tend to carry positive charges, which results in attraction of the bacteria, which, in turn, results in damage to the cell membrane and the enzyme system of the bacteria and the eventual destruction of the bacteria.

## Claims

1. An antimicrobial sanitary ware comprising:
a substrate (2); and
an antimicrobial film formed on said substrate (2) and comprising a protective layer (3) and antimicrobial metal particles (4) that are dispersed in said protective layer (3);
wherein said protective layer (3) is made from a compound selected from the group consisting of metal nitrides and metal carbides; and
wherein said antimicrobial metal particles (4) are made from a metal selected from the group consisting of silver, zinc, and copper.

2. An antimicrobial sanitary ware as claimed in Claim 1, wherein said compound of said protective layer is a metal nitride.

3. An antimicrobial sanitary ware as claimed in Claim 1 or 2, wherein said compound of said protective layer is selected from the group consisting of zirconium nitride, chromium nitride, and titanium nitride.

4. An antimicrobial sanitary ware as claimed in any preceding Claim, wherein said compound of said protective layer is zirconium nitride.

5. An antimicrobial sanitary ware as claimed in any preceding Claim, wherein said substrate is made from a material selected from the group consisting of copper alloy, zinc alloy, stainless steel, ceramics, and plastics.

6. An antimicrobial sanitary ware as claimed in any preceding Claim, wherein said substrate is made from copper alloy.

7. A method for making an antimicrobial sanitary ware comprising the steps of:
placing a substrate in a sputtering chamber in a sputter; and
simultaneously sputtering a first metal target of a first metal and a second metal target of a second metal through closed-field unbalanced magnetron sputtering techniques, which form a continuously closed magnetic field around the substrate, so as to react the first metal into a metal compound which is subsequently deposited on the substrate to form a protective layer, and so as to generate metal particles of the second metal that are dispersed in the protective layer;
wherein the second metal is selected from the group consisting of silver, zinc, and copper;
wherein the metal compound is selected from the group consisting of metal nitrides and metal carbides;
wherein the sputtering for the second metal target is conducted at a voltage of less than 20V, and a current ranging from 0.3-0.5A; and
wherein a negative biased voltage of greater than - 80V is applied to said substrate.

8. A method as claimed in Claim 7, wherein the first metal is selected from the group consisting of zirconium, chromium and titanium.

9. A method as claimed in Claim 7 or 8, wherein the metal compound is selected from the group consisting of zirconium nitride, chromium nitride and titanium nitride.

10. A method as claimed in Claim 7, 8 or 9, wherein the substrate is made from a material selected from the group consisting of copper alloy, zinc alloy, stainless steel, ceramics and plastics.

11. A method as claimed in any of Claims 7 to 10, wherein the sputtering for the first metal target is conducted at a voltage ranging from 20-50V, and a current ranging from 3.5-4.5A.

12. A method as claimed in Claim 7, wherein the sputtering is conducted at a temperature ranging from 80-180 °C.

13. A method as claimed in Claim 12, wherein the sputtering is conducted at a pressure ranging from 0.013-2.667 Pa (0.1-20 mTorr).

14. A method as claimed in Claim 12 or 13, wherein the sputtering time ranges from 3-13 minutes.

## Patentansprüche

1. Antimikrobieller Sanitärartikel, der Folgendes umfasst:
ein Substrat (2); und
einen antimikrobiellen Film, der auf dem genannten Substrat (2) ausgebildet ist und eine Schutzschicht (3) und antimikrobielle Metallpartikel (4) umfasst, die in der genannten Schutzschicht (3) dispergiert sind;
wobei die genannte Schutzschicht (3) aus einer Verbindung gefertigt ist, die aus der Gruppe bestehend aus Metallnitriden und Metallcarbiden ausgewählt ist; und
wobei die genannten antimikrobiellen Metallpartikel (4) aus einem Metall gefertigt sind, das aus der Gruppe bestehend aus Silber, Zink und Kupfer ausgewählt ist.

2. Antimikrobieller Sanitärartikel nach Anspruch 1, wobei die genannte Verbindung der genannten Schutzschicht ein Metallnitrid ist.

3. Antimikrobieller Sanitärartikel nach Anspruch 1 oder 2, wobei die genannte Verbindung der genannten Schutzschicht aus der Gruppe bestehend aus Zirconiumnitrid, Chromnitrid und Titannitrid ausgewählt ist.

4. Antimikrobieller Sanitärartikel nach einem der vorherigen Ansprüche, wobei die genannte Verbindung der genannten Schutzschicht Zirconiumnitrid ist.

5. Antimikrobieller Sanitärartikel nach einem der vorherigen Ansprüche, wobei das genannte Substrat aus einem Material gefertigt ist, das aus der Gruppe bestehend aus Kupferlegierung, Zinklegierung, Edelstahl, Keramik und Plastik ausgewählt ist.

6. Antimikrobieller Sanitärartikel nach einem der vorherigen Ansprüche, wobei das genannte Substrat aus Kupferlegierung gefertigt ist.

7. Verfahren zur Herstellung eines antimikrobiellen Sanitärartikels, das die folgenden Schritte umfasst:
Platzieren eines Substrats in einer Sputterkammer in einer Sputtervorrichtung;
und
gleichzeitiges Sputtern eines ersten Metalltargets aus einem ersten Metall und eines zweiten Metalltargets aus einem zweiten Metall durch unsymmetrische Magnetron-Sputtertechniken mit eingeschlossenem Magnetfeld, die ein kontinuierlich geschlossenes Magnetfeld um das Substrat bilden, um das erste Metall in eine Metallverbindung umzusetzen, die nachfolgend zum Bilden einer Schutzschicht auf das Substrat aufgebracht wird, und um Metallpartikel des zweiten Metalls zu erzeugen, die in der Schutzschicht dispergiert sind;
wobei das zweite Metall aus der Gruppe bestehend aus Silber, Zink und Kupfer ausgewählt ist;
wobei die Metallverbindung aus der Gruppe bestehend aus Metallnitriden und Metallcarbiden ausgewählt ist;
wobei das Sputtern für das zweite Metalltarget bei einer Spannung von weniger als 20 V und einem Strom im Bereich von 0,3-0,5 A durchgeführt wird; und
wobei eine negative Spannung von mehr als -80V an das genannte Substrat angelegt wird.

8. Verfahren nach Anspruch 7, wobei das erste Metall aus der Gruppe bestehend aus Zirconium, Chrom und Titan ausgewählt ist.

9. Verfahren nach Anspruch 7 oder 8, wobei die Metallverbindung aus der Gruppe bestehend aus Zirconiumnitrid, Chromnitrid und Titannitrid ausgewählt ist.

10. Verfahren nach Anspruch 7, 8 oder 9, wobei das Substrat aus einem Material gefertigt ist, das aus der Gruppe bestehend aus Kupferlegierung, Zinklegierung, Edelstahl, Keramik und Plastik ausgewählt ist.

11. Verfahren nach einem der Ansprüche 7 bis 10, wobei das Sputtern für das erste Metalltarget bei einer Spannung im Bereich von 20-50 V und einem Strom im Bereich von 3,5-4,5 A durchgeführt wird.

12. Verfahren nach Anspruch 7, wobei das Sputtern bei einer Temperatur im Bereich von 80-180°C durchgeführt wird.

13. Verfahren nach Anspruch 12, wobei das Sputtern bei einem Druck im Bereich von 0,013-2,667 Pa (0,1-20 mTorr) durchgeführt wird.

14. Verfahren nach Anspruch 12 oder 13, wobei die Sputterzeit im Bereich von 3-13 Minuten liegt.

## Revendications

1. Matériel sanitaire antimicrobien comprenant :
un substrat (2) ; et
un film antimicrobien formé sur ledit substrat (2) et comprenant une couche de protection (3) et des particules métalliques antimicrobiennes (4) qui sont dispersées dans ladite couche de protection (3) ;
où ladite couche de protection (3) est constituée d'un composé sélectionné parmi le groupe composé de nitrures métalliques et carbures métalliques ; et
où lesdites particules métalliques antimicrobiennes (4) sont constituées d'un métal sélectionné parmi le groupe composé d'argent, de zinc et de cuivre.

2. Matériel sanitaire antimicrobien tel que revendiqué à la Revendication 1, où ledit composé de ladite couche de protection est un nitrure métallique.

3. Matériel sanitaire antimicrobien tel que revendiqué à la Revendication 1 ou 2, où ledit composé de ladite couche de protection est sélectionné parmi le groupe composé de nitrure de zirconium, nitrure de chrome et nitrure de titane.

4. Matériel sanitaire antimicrobien tel que revendiqué dans une quelconque Revendication précédente, où ledit composé de ladite couche de protection est du nitrure de zirconium.

5. Matériel sanitaire antimicrobien tel que revendiqué dans une quelconque Revendication précédente, où ledit substrat est constitué d'un matériau sélectionné parmi le groupe composé d'alliage de cuivre, alliage de zinc, acier inoxydable, céramique et plastique.

6. Matériel sanitaire antimicrobien tel que revendiqué dans une quelconque Revendication précédente, où ledit substrat est constitué d'alliage de cuivre.

7. Procédé pour fabriquer un matériel sanitaire antimicrobien comprenant les étapes consistant à :
placer un substrat dans une chambre de pulvérisation dans une pulvérisation ; et
pulvériser simultanément une première cible métallique d'un premier métal et une seconde cible métallique d'un second métal par le biais des techniques de pulvérisation magnétron non équilibrée à champ fermé, qui forment un champ magnétique constamment fermé autour du substrat, de manière à faire réagir le premier métal en un composé métallique qui est ensuite déposé sur le substrat pour former une couche de protection, et de manière à générer des particules métalliques du second métal qui sont dispersées dans la couche de protection ;
où le second métal est sélectionné parmi le groupe composé d'argent, de zinc et de cuivre ;
où le composé métallique est sélectionné parmi le groupe composé de nitrures métalliques et carbures métalliques ;
où la pulvérisation pour la seconde cible métallique est réalisée à une tension inférieure à 20 V, et à un courant allant de 0,3 à 0,5 A ; et
où une tension négative polarisée de plus de -80 V est appliquée audit substrat.

8. Procédé tel que revendiqué à la Revendication 7, où le premier métal est sélectionné parmi le groupe composé de zirconium, chrome et titane.

9. Procédé tel que revendiqué à la Revendication 7 ou 8, où le composé métallique est sélectionné parmi le groupe composé de nitrure de zirconium, nitrure de chrome et nitrure de titane.

10. Procédé tel que revendiqué à la revendication 7, 8 ou 9, où le substrat est constitué d'un matériau sélectionné parmi le groupe composé d'alliage de cuivre, alliage de zinc, acier inoxydable, céramique et plastique.

11. Procédé tel que revendiqué dans une quelconque des Revendications 7 à 10, où la pulvérisation pour la première cible métallique est réalisée à une tension allant de 20 à 50 V, et à un courant allant de 3,5 à 4,5 A.

12. Procédé tel que revendiqué à la Revendication 7, où la pulvérisation est réalisée à une température allant de 80 à 180 °C.

13. Procédé tel que revendiqué à la Revendication 12, où la pulvérisation est réalisée à une pression allant de 0,013 à 2,667 Pa (0,1-20 mTorr).

14. Procédé tel que revendiqué à la Revendication 12 ou 13, où la durée de pulvérisation va de 3 à 13 minutes.
